# FASCICULE DE BREVET EUROPEEN

(11) **EP 3 038 160 B1**
(45) Date de publication et mention de la délivrance du brevet: **02.09.2020**
(21) Numéro de dépôt: 15199594.1
(22) Date de dépôt: 11.12.2015
(51) Int. Cl.: H01L 21/336, H01L 29/78, H01L 29/10, H01L 29/786, H01L 29/423, H01L 29/49

(54) **TRANSISTOR COMPRENANT UN CANAL MIS SOUS CONTRAINTE EN CISAILLEMENT ET PROCEDE DE FABRICATION**
TRANSISTOR, DER EINEN KANAL UMFASST, DER EINER SCHERSPANNUNG AUSGESETZT WIRD, UND SEIN HERSTELLUNGSVERFAHREN
TRANSISTOR COMPRISING A CHANNEL PLACED UNDER SHEAR STRESS AND MANUFACTURING METHOD

(30) Priorité: 23.12.2014 FR 1463176
(43) Date de publication de la demande: 29.06.2016
(73) Titulaire: COMMISSARIAT À L'ÉNERGIE ATOMIQUE ET AUX ÉNERGIES ALTERNATIVES, 75015 Paris (FR)
(72) Inventeur: AUGENDRE, Emmanuel, 38330 MONTBONNOT (FR); ARGOUD, Maxime, 38110 LA CHAPELLE DE LA TOUR (FR); MAITREJEAN, Sylvain, 38000 GRENOBLE (FR); MORIN, Pierre, NEW YORK, NY 12208 (US); TIRON, Raluca, 38950 SAINT-MARTIN-LE-VINOUX (FR)
(74) Mandataire: Esselin, Sophie

(56) Documents cités:
- EP-A1- 2 346 078
- JP-A- S60 175 458
- US-A1- 2008 128 764
- US-A1- 2010 320 510
- US-B1- 6 198 141
- SKOTNICKI T ET AL: "HEAVILY DOPED AND EXTREMELY SHALLOW JUNCTIONS ON INSULATOR - BY SONCTION (SILICON CUT-OFF JUNCTION) PROCESS", INTERNATIONAL ELECTRON DEVICES MEETING 1999. IEDM. TECHNICAL DIGEST. WASHINGTON, DC, DEC. 5 - 8, 1999; [INTERNATIONAL ELECTRON DEVICES MEETING], NEW YORK, NY : IEEE, US, 1 août 2000 (2000-08-01), pages 513-516, XP000933240, ISBN: 978-0-7803-5411-1

## Description

Le domaine de l'invention est celui des matériaux semi-conducteurs notamment utilisés dans la microélectronique et plus précisément celui des transistors à effet de champ de type transistor à effet de champ à grille isolée plus couramment nommé MOSFET (acronyme anglais de *Metal Oxide Semiconductor Field Effect Transistor* - qui se traduit par *transistor à effet de champ à structure métal-oxyde-semiconducteur*).

Ce type de transistor comprend de manière générale, une source et un drain séparés par canal dans lequel peuvent circuler des porteurs de charge et une grille de commande, ladite grille étant séparée du canal conducteur, par un matériau isolant encore appelé isolant de grille.

Dans ce domaine, il peut être avantageux d'introduire de la contrainte mécanique dans le canal des dispositifs :
- pour augmenter la mobilité des porteurs de charges : à polarisation fixée, le courant à l'état passant s'en trouve augmenté ainsi que les performances dynamiques du circuit ou
- pour permettre d'obtenir d'un dispositif le même courant à tension de polarisation réduite, assurant au circuit une performance inchangée à plus faible puissance dissipée.

La mise en compression ou en traction est notamment connue dans le cadre d'alliage de SiGe pour augmenter la mobilité respective des trous et des électrons comme décrit dans : M. V. Fischetti and S.E. Laux, « Band structure, deformation potentials, and carrier mobility in strained Si, Ge, and SiGe Alloys », Journal of Applied Physics 80, 2234 (1996); doi: 10.1063/1.363052.

Sur la base des coefficients piézorésistifs, il est également possible d'attendre un bénéfice d'une contrainte en cisaillement sur la mobilité des électrons et des trous comme expliqué dans O. Weber et al., « Examination of Additive Mobility Enhancements for Uniaxial Stress Combined with Biaxially Strained Si, Biaxially Strained SiGe and Ge Channel MOSFETs », Technical Digest of the International Device Meeting, 2007, pp. 719-722. Une structure introduisant de la contrainte de cisaillement dans un transistor de type p a également été proposée et décrite dans le brevet US 7 274 084. Plus précisément, dans cette structure, la contrainte en cisaillement est introduite dans le dispositif pMOSFET par le biais de deux régions grisées périphériques situées au contact de la zone active du transistor et remplies d'un matériau compressif ou tensile. Néanmoins, comme représenté sur la figure 1 de ce brevet, et reprise dans la figure 1 de la présente description, la structure proposée comporte une source de déformation éloignée du canal et donc d'influence limitée.

Le document US 6198141 B1 divulgue un transistor à effet de champ comportant un canal, ledit canal comportant un ensemble de perforations.

C'est pourquoi dans ce contexte, la présente invention a pour objet un transistor à effet de champ dans lequel une contrainte en cisaillement est introduite directement dans la région du canal pour être plus efficiente et ce à partir d'un dispositif MOS dont le canal est préalablement mis sous contrainte en compression ou en tension (biaxiale). La contrainte en cisaillement est générée en raison de la présence d'au moins une perforation le long d'au moins un bord de canal côté source et/ou un bord de canal côté drain.

Plus précisément la présente invention a pour objet un transistor à effet de champ comportant une zone active présentant une source, un canal, un drain, et une grille de commande positionnée au niveau dudit canal permettant la circulation d'un courant dans ledit canal entre la source et le drain selon un axe x, ledit canal comprenant :
- un premier bord de séparation avec ladite source ;
- un second bord de séparation avec ledit drain ;
- ledit canal étant contraint en tension ou en compression ;
caractérisé en ce que ledit canal comporte une perforation ou un ensemble de perforations localisée(s) le long uniquement dudit premier et/ou dudit second bord dudit canal de manière à créer également au moins une contrainte de cisaillement au niveau dudit canal.

Selon une variante de l'invention, le transistor comprend une couche de matériau semiconducteur à la surface d'une couche d'oxyde enterrée (BOX), ladite couche de matériau semiconducteur étant précontrainte en tension ou en compression à la surface de ladite couche d'oxyde enterré.

Selon une variante de l'invention, le canal étant en silicium, en germanium ou dans un alliage SiGe, la source et le drain comprennent des espèces pouvant être des alliages d'éléments de la colonne IV, contribuant à mettre le canal en tension ou en compression de façon uniaxiale.

Selon une variante de l'invention, la zone active est noyée dans une zone diélectrique présentant une partie supérieure, la grille étant située dans une cavité de grille définie dans ladite partie supérieure de ladite zone.

Selon une variante de l'invention, le matériau semiconducteur est un alliage de SiGe à la surface d'une couche d'oxyde de silicium.

Selon une variante de l'invention, le transistor comprend un ensemble de perforations distribuées en quinconce le long desdits premier et second bord du canal. Cette variante avantageuse de réseau de perforations hexagonal dans le plan correspond à une répartition particulièrement favorable au cisaillement et à une meilleure contrainte en cisaillement.

Selon une variante de l'invention, le transistor comprend un ensemble de perforations distribuées sur un seul bord de canal, côté source ou côté drain.

Selon une variante de l'invention, la ou les perforations est(sont) remplie(s) par au moins un matériau de remplissage pouvant être un matériau présentant un module d'Young élevé (typiquement supérieur à 200 GPa) et pouvant être du HfO₂.

Selon une variante de l'invention, un des matériaux de remplissage de ladite(desdites) perforations(s) recouvre également les parois internes de la cavité de grille.

Selon une variante de l'invention, les dimensions des perforations sont de l'ordre de quelques nanomètres, l'épaisseur du canal étant comprise entre quelques nanomètres et une centaine de nanomètres.

Selon une variante de l'invention, la zone active présentant une largeur W' selon un axe y perpendiculaire à l'axe x, ladite largeur répond à l'équation suivante : W' = n L₀ avec n entier et L₀ la distance entre deux perforations adjacentes, le nombre de perforations le long du premier bord étant identique au nombre de perforations le long du second bord selon l'axe y.

L'invention a aussi pour objet un dispositif comprenant un ensemble de transistors selon la présente invention à la surface d'un substrat.

Dans cette configuration collective et selon une variante de l'invention, les distances entre les cavités de grille des transistors répondent aux critères suivants :
- selon l'axe x et selon lequel est définie la longueur de canal L, la distance λ entre deux grilles adjacentes est égale à m.a₀, avec m entier et a₀ = √3/2 L₀ (λ = m.a₀), a₀ étant la distance entre deux rangées de perforations adjacentes ;
- selon l'axe y et selon lequel est définie la largeur de la zone active W', la distance ω entre deux grilles adjacentes est égale à n.L₀/2 avec n entier (ω = n.L₀/2).

L'invention a encore pour objet un procédé de fabrication d'un transistor à effet de champ comportant une zone active présentant un source, un canal, un drain, et une grille de commande positionnée au niveau dudit canal permettant de contrôler un flux de porteurs de charge dans ledit canal, caractérisé en ce qu'il comprend les étapes suivantes :
- la réalisation d'une structure de transistor MOSFET comportant une source, un canal, un drain et une grille sacrificielle au dessus dudit canal, ledit canal étant contraint en tension ou en compression ;
- le dépôt d'une couche diélectrique d'encapsulation de ladite structure avec un diélectrique pouvant être un oxyde ;
- la gravure sélective de ladite grille sacrificielle permettant de définir une cavité de grille au travers de ladite couche de diélectrique d'encapsulation ;
- le dépôt d'un copolymère à blocs comprenant une première espèce et une seconde espèce dans ladite cavité de grille présentant une première paroi interne côté source, dite premier bord du canal, et une seconde paroi interne côté drain, dite second bord du canal ;
- l'élimination de la première ou de la seconde espèce de manière à définir des motifs de masquage positionnés en regard d'au moins une desdites parois et débouchant en fond de cavité de grille ;
- la réalisation de perforation(s) localisée(s) le long uniquement dudit premier et/ou dudit second bord dudit canal
- le dépôt d'au moins un matériau de grille dans la cavité de grille en regard du canal perforé.

Selon une variante de l'invention, le procédé comprend une étape de remplissage de(des) perforation(s) avec au moins un matériau de remplissage.

Selon une variante de l'invention, le procédé comprend le dépôt suivi du recuit et rinçage d'une couche de neutralisation qui permet le greffage de celle-ci, préalable au dépôt de la couche de copolymère à blocs, de manière à permettre une orientation privilégiée des perforations dans ledit canal.

Selon une variante de l'invention, le copolymère à blocs est du PS-b-PMMA, le matériau de la couche de neutralisation étant du PS-r-PMMA.

Selon une variante de l'invention, ledit procédé comprend le dépôt d'une couche de matériau de remplissage sur les parois internes de la cavité de grille par un matériau de remplissage, présentant un fort module d'Young (typiquement supérieur à 200 GPa) pouvant être du HfO₂.

Selon une variante de l'invention, le procédé comprend le traitement localisé de ladite couche de neutralisation de manière à ne rendre active ladite couche de neutralisation qu'au niveau d'un des deuxdits bords de drain ou de source.

Selon une variante de l'invention, ledit traitement est réalisé avec un faisceau d'implantation ionique d'hydrogène faisant un angle de tilt :
θ = arctan(L/H) avec L la longueur du canal selon l'axe x et H la profondeur de ladite cavité de grille.

Ce procédé est particulièrement bien adapté pour définir des perforations sur un seul des bords de source ou de drain.

L'invention sera mieux comprise et d'autres avantages apparaîtront à la lecture de la description qui va suivre donnée à titre non limitatif et grâce aux figures annexées parmi lesquelles :
- la figure 1 illustre une structure de l'art antérieur comprenant des zones permettant d'introduire des contraintes en cisaillement ;
- la figure 2 schématise une structure de transistor selon l'invention comprenant un canal comportant des perforations en quinconce ;
- la figure 3 illustre la composante en x du tenseur de stress obtenue dans une structure simulée telle que celle illustrée en figure 2 ;
- la figure 4 illustre la composante en y du tenseur de stress obtenue dans une structure simulée telle que celle illustrée en figure 2 ;
- la figure 5 illustre la composante de cisaillement du tenseur de stress obtenue dans une structure simulée telle que celle illustrée en figure 2 ;
- les figures 6a à 6l illustrent les étapes d'un exemple de procédé de fabrication d'un transistor selon l'invention ;
- la figure 7 illustre un exemple de dispositif de l'invention comprenant plusieurs transistors réalisés de manière collective dans le cas du dépôt d'un copolymère à blocs d'épaisseur inférieure à la profondeur de la cavité de grille laissée après retrait de la grille sacrificielle ;
- la figure 8 illustre un exemple de dispositif de l'invention comprenant plusieurs transistors réalisés de manière collective dans le cas du dépôt d'un copolymère à blocs d'épaisseur supérieure à la profondeur de la cavité de grille laissée après retrait de la grille sacrificielle ;
- les figures 9a à 9c illustrent les étapes concernant le dépôt préalable d'une couche de neutralisation et le dépôt d'une couche de copolymère à blocs, incluses dans un exemple de procédé de fabrication d'un transistor selon l'invention dans le cas de la réalisation de perforations sur un seul des deux bords du canal.

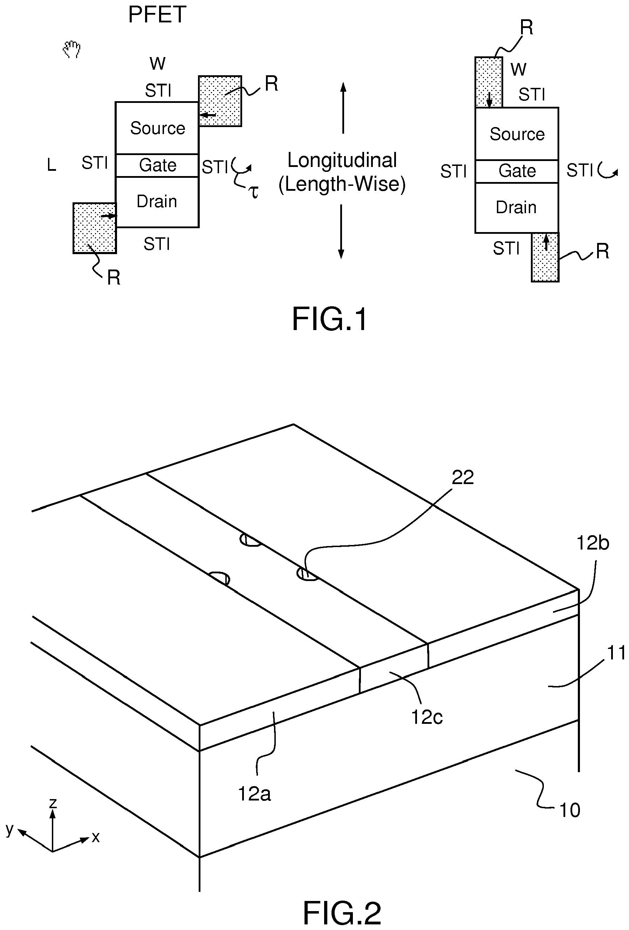

De manière générale, le transistor de type MOSFET selon la présente invention comprend comme schématisé en figure 2, à la surface d'un substrat 10 et d'une couche enterrée d'oxyde 11, un film de matériau semiconducteur dans lequel sont réalisés de manière classique une source 12a, un drain 12b séparés par un canal 12c (la grille n'est pas représentée pour faire figurer les perforations). Seules trois perforations sont montrées, mais dans le principe et de manière générale, il est intéressant de réaliser des perforations sur l'ensemble de la largeur du canal (dimension suivant l'axe y), sur au moins l'un des deux bords. Selon la présente invention, le canal 12c peut ainsi avantageusement comprendre des perforations disposées en quinconce au niveau des deux bords permettant de générer au moins une contrainte de cisaillement.

Le demandeur a réalisé des simulations permettant de mettre en évidence l'existence de contrainte en cisaillement.

Pour cela les dimensions de la structure simulée de transistor pMOS à canal SiGe 25% mis en compression sont les suivantes pour une structure SGOI : « SIGe on insulator ». Le canal 12c et les source/drain 12a et 12b du transistor sont formés sur un film de SiGe 25% reposant sur un oxyde enterré 11 :
W_{_SOI} : largeur totale (selon y) du film SGOI, W_{SOI} = 100nm
L_{_SOI} : longueur totale (selon x) du film SGOI, L_{_SOI} = 100nm

Pour la simulation, le film SGOI repose sur un oxyde enterré (BOX reposant lui-même sur le substrat, Sub (10), dont les largeur et longueur respectives sont W_{_Sub}=140nm et L_{_Sub} = 140nm.

Sa et Sb sont les longueurs (dans la direction x) respectives des source (12a) et drain (12b). Sa = Sb = 41nm.

Une telle structure peut être élaborée de la façon suivante et ce pour précontraindre le canal : une couche de SiGe est mise en contrainte compressive par un procédé d'enrichissement. A partir d'un film Si relaxé (film SOI), l'enrichissement commence par une épitaxie de SiGe suivie d'une oxydation de cette couche au cours de laquelle l'oxyde formé est un SiO₂, le germanium du SiGe étant repoussé dans le film Si qui s'enrichit progressivement pour devenir un film de SiGe en compression (dans le plan, en raison du paramètre de maille du film Si relaxé initial).

La structure simulée comprend une couche d'oxyde BOX d'une épaisseur H_BOX de 25 nm, une épaisseur de canal H_SOI de 6 nm.

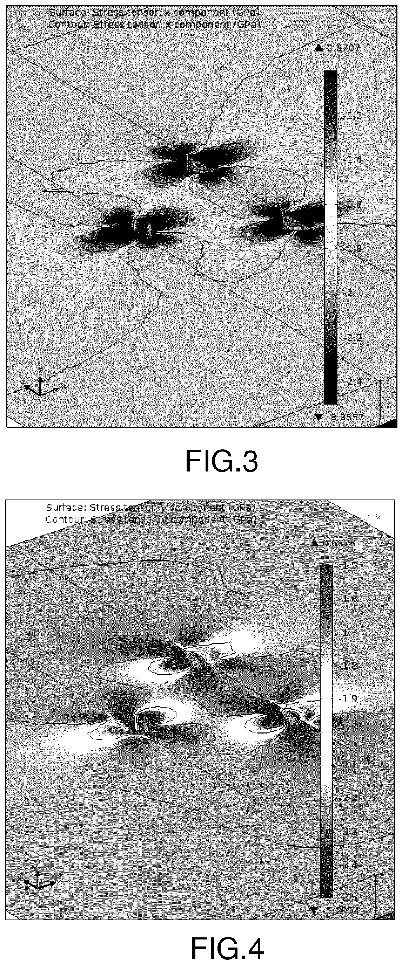

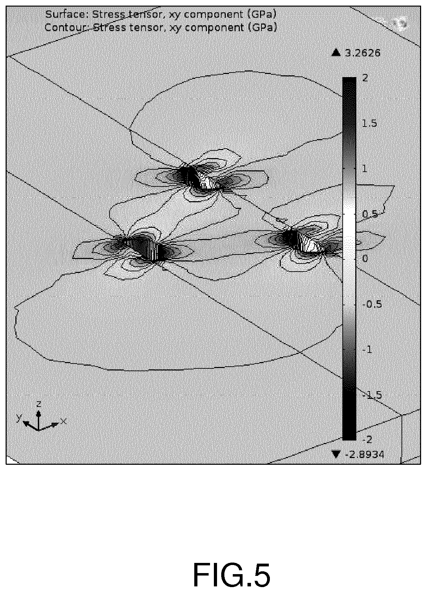

Les dimensions de la structure simulée sont les suivantes : essentiellement une largeur (selon l'axe y) de 100nm, une longueur totale (selon l'axe x) de 100nm, une longueur de canal (selon l'axe x) de 18nm, avec une couche de SiGe de 6nm d'épaisseur. La figure 3 illustre les résultats de la composante selon l'axe x, du tenseur de stress. La figure 4 illustre les résultats de la composante selon l'axe y, du tenseur de stress. La figure 5 illustre les résultats de la composante de cisaillement du tenseur de stress .

Il ressort de l'ensemble de ces figures que les perforations apportent les bénéfices suivants sur le transport :
- la création de deux zones obliques sous contrainte de cisaillement. La répartition des perforations en quinconce permet aux zones obliques créées de part et d'autre de la grille de se superposer et d'occuper la longueur du canal (figure 5) ;
- une relaxation transversale de la contrainte biaxiale initiale (selon l'axe y) et une augmentation conjointe de sa composante longitudinale (selon l'axe x) à la transition source/drain-canal, au voisinage immédiat des perforations (figures 3 et 4).

Pour obtenir un tel transistor, de manière générale, le procédé de fabrication selon la présente invention consiste principalement à :
- réaliser un dispositif sur film mince en contrainte biaxiale dans une configuration « gate last » (les matériaux de grille définitifs sont introduits après réalisation des sources et drain autour d'un canal et d'une grille sacrificielle) ;
- introduire au moins une perforation et avantageusement un ensemble de perforations en quiconque dans le canal du transistor à l'aide de copolymère à blocs cylindriques, après le retrait de la grille sacrificielle ;
- réaliser la grille du transistor (les matériaux de grille définitifs sont introduits après réalisation des sources et drain autour de la grille sacrificielle).

Selon la présente invention, le canal précontraint, permet ainsi à des perforations de faibles dimensions de générer des contraintes de cisaillement d'amplitude significative.

Avantageusement, il est possible de précontraindre le canal par les moyens suivants (indépendants et additifs) de mise en contrainte du canal :
- par une mise en contrainte globale, par construction, du matériau de canal. C'est le cas du sSOI (couche mince de Si mis en tension) ou par l'utilisation d'un alliage SiGe mis en compression car obtenu par un procédé d'enrichissement sur Si ;
- par une mise en contrainte locale par les source et drain. La réalisation d'épitaxies contraintes dans les zones de source et drain (en général alliages d'éléments de la colonne IV, par exemple SiGe pour mettre le canal en compression, SiC pour mettre le canal en tension). Cette approche est avantageuse dans le cas de la présente invention car l'amplitude de la contrainte apportée par les source/drain est exacerbée par l'utilisation d'une grille sacrificielle permettant de réaliser des perforations avant la réalisation de la grille définitive (étape de remplacement de grille) ;
- par la mise en contrainte locale par le dépôt de couches contraintes (de type *'contact etch stop layer')* comme mentionné dans la publication H. S. Yang, et al.; "Dual Stress Liner for High Performance Sub-45nm Gate Length SOI CMOS Manufacturing", Technical Digest of IEDM 2004, pp. 1075-107*.*

Le Demandeur décrit ci-après un exemple de procédé de fabrication d'un transistor selon l'invention comprenant des perforations dans son canal au niveau du premier bord de séparation avec la source et du second bord de séparation avec le drain.

### Premier exemple de procédé de fabrication d'un transistor MOSFET selon l'invention :

Une première série d'étapes concerne l'élaboration d'un transistor avec une grille sacrificielle :

### Etape 1 :

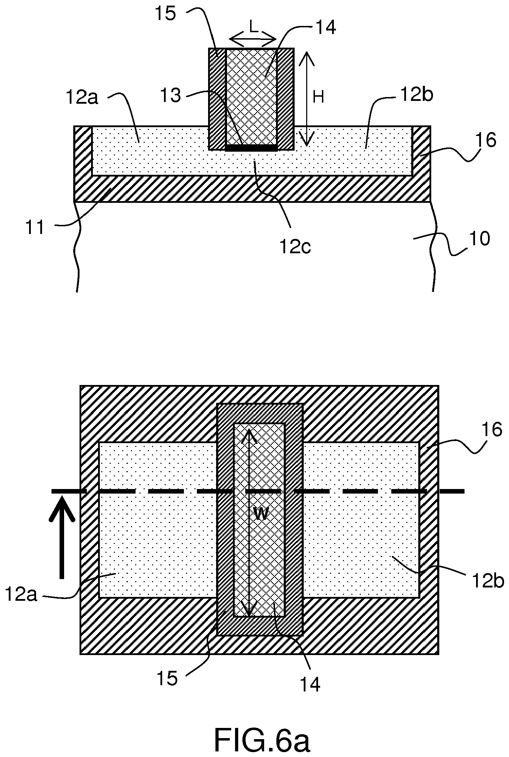

On réalise dans un premier temps un transistor sur un film mince de matériau semiconducteur sous contrainte bi-axiale (en tension ou en compression), comprenant une source **S,** une grille **G** et un drain **D** à la surface d'une couche d'oxyde enterrée, à la surface d'un substrat couramment dénommée **BOX** correspondant à l'acronyme anglais de « buried oxide ». Le transistor présente une longueur de canal **L,** une hauteur de grille **H,** une largeur de cavité de grille **W** et une épaisseur de canal **t.** La figure 6a illustre cette structure comprenant à la surface d'un substrat **10,** une couche d'oxyde enterré **11,** à la surface de laquelle sont réalisés la source 12a, et le drain 12b de part et d'autre du canal 12c, dans un film mince de matériau semiconducteur mis sous contrainte. Des espaceurs **15** sur les flancs de la grille dite sacrificielle **14,** typiquement en nitrure de silicium), sont prévus destinés à isoler à terminaison, la grille du drain et de la source. La zone active comprenant la source, la grille et le drain peut être délimitée par des éléments diélectriques **16** pouvant avantageusement être de type oxyde. La grille de ce transistor est sacrificielle et réalisée typiquement en silicium polycristallin, sur un oxyde de grille **13** qui peut être de l'oxyde de silicium de très faible épaisseur, typiquement de l'ordre de 2 à 5 nm.

(Dans les autres étapes du procédé décrites ci-après, le substrat 10 est présent mais non représenté).

### Etape 2 :

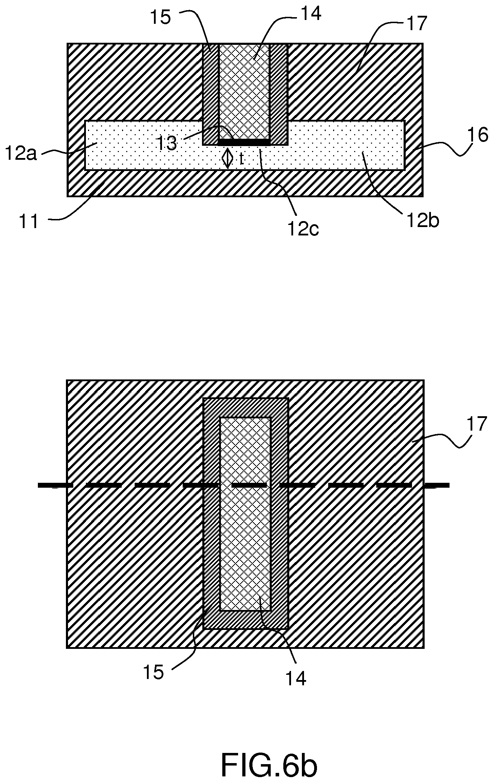

On procède au dépôt d'une couche d'oxyde et à une opération de planarisation de cette couche d'oxyde par polissage mécanochimique (CMP) jusqu'à l'exposition du sommet de la grille La figure 6b illustre le dépôt de cette couche d'oxyde **17** après planarisation.

### Etape 3 :

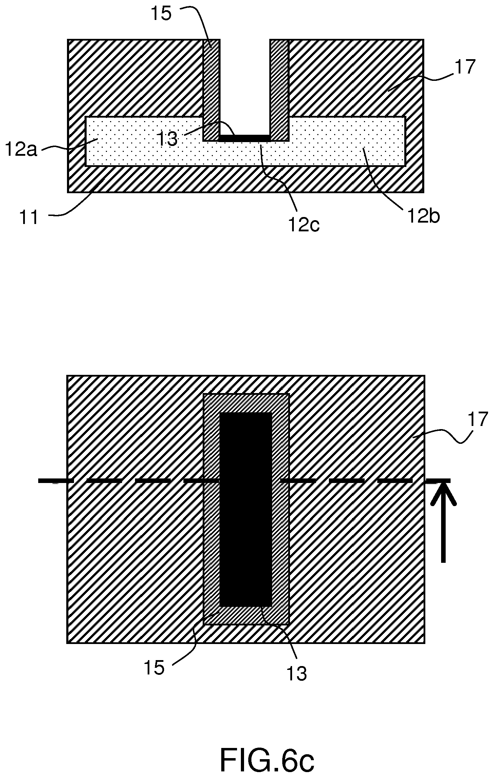

On procède lors de cette troisième étape à la gravure de la grille sacrificielle **14** de façon sélective par rapport à l'oxyde de grille **13** et aux espaceurs **15,** comme illustré en figure 6c, permettant de dégager une cavité de grille.

Une seconde série d'étapes concerne la réalisation des motifs de perforation dans le masque dur d'oxyde en fond de cavité :

### Etape 4

On procède au dépôt d'une couche dite de neutralisation permettant de préparer la surface de fond de cavité de grille. Plus précisément, on réalise l'étalement et la réticulation d'une couche de copolymères à blocs.

Dans le cas d'un copolymère cylindrique de type par exemple PS-b-PMMA, destiné à réaliser des perforations, il est possible de contrôler l'état de surface de façon à obtenir des demi-cylindres de PMMA (poly-méthylméthacrylate) qui se placent suivant un réseau hexagonal dans une matrice de PS (polystyrène) et tendent à s'aligner verticalement et à cheval sur les bords de cavité de grille et ce par exemple en utilisant un copolymère dit « aléatoire » PS-r-PMMA qui permet l'orientation verticale des cylindres PMMA : grâce à la couche de neutralisation, les deux blocs du copolymère à blocs sont d'affinité équivalente avec les bords et le fond de la cavité.

Les conditions expérimentales d'une telle préparation sont décrites dans l'article de R. Tiron et al. SPIE 2012, « Pattern density multiplication by direct self assembly of block copolymers : Towards 300 nm CMOS requirements » Vol.8323.

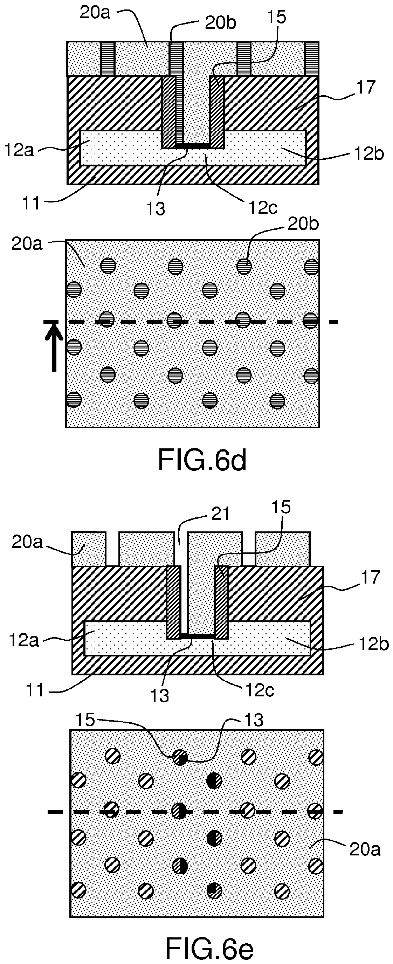

La figure 6d illustre ainsi le dépôt d'une couche de copolymère à blocs destinée à la réalisation des perforations, au niveau de la cavité de grille (la couche de neutralisation n'est pas représentée), définissant des motifs **20b** de PMMA dans du polystyrène **20a.**

### Etape 5 :

On procède alors à l'élimination de la phase PMMA **20b** (par exemple en humide par une solution d'acide acétique après insolation UV), créant des cavités verticales débouchantes. La figure 6e illustre les ouvertures **21** ainsi créées dans la couche de copolymère bloc. Une étape de gravure ionique réactive « RIE » supplémentaire (plasma Ar/O₂) permet d'éliminer les résidus de la couche de traitement de surface PS-r-PMMA présents en fond de cavité.

La vue de dessus met en évidence que les perforations mettent à nu une partie des espaceurs **15** et de l'oxyde de grille **13** en fond de cavité de grille.

### Etape 6 :

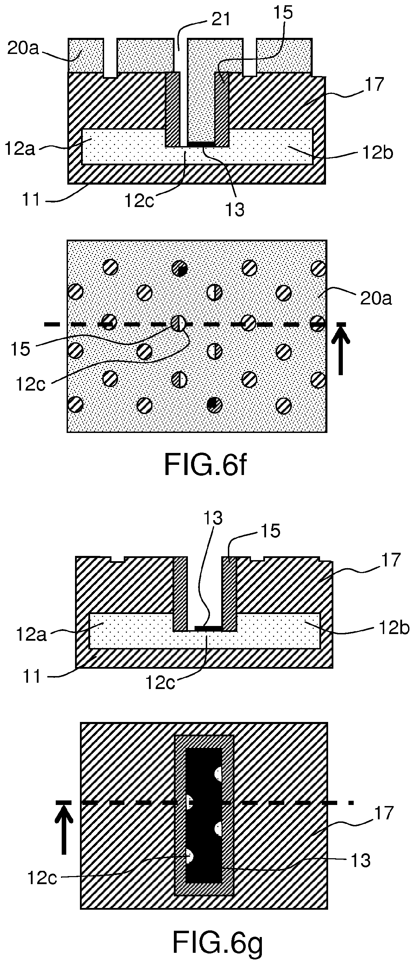

On procède à la gravure de l'oxyde de grille sacrificiel à travers les ouvertures du masque de PS. La figure 6f illustre les ouvertures **21** ainsi prolongées dans l'oxyde de grille **13.** De façon secondaire, la gravure de l'oxyde de fond de cavité s'accompagne d'une gravure similaire de l'oxyde au fond des trous extérieurs à la cavité de grille, que l'on peut éviter en réalisant une surface supérieure en nitrure, par exemple.

Une troisième série d'étapes concerne la réalisation de perforations dans le canal :

### Etape 7 :

On procède lors de cette étape au retrait du masque dur constitué par des éléments **20a,** comme illustré en figure 6g qui met en évidence des éléments dégagés de canal **12c** et de l'oxyde de grille restant **13.**

### Etape 8 :

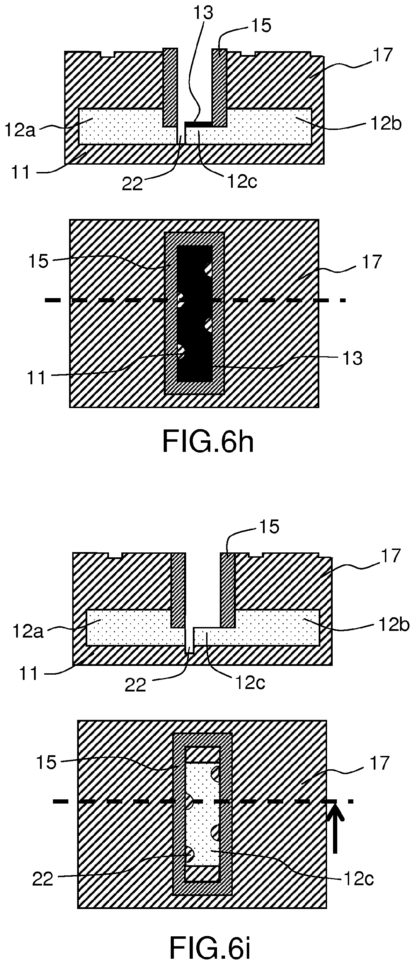

On procède à la gravure du canal en utilisant l'oxyde sacrificiel de grille **13** comme masque dur, comme illustré en figure 6h.

La gravure débouche sur la couche d'oxyde BOX **11** , comme illustré en figure 6h qui met en évidence les perforations **22** réalisées au niveau de la partie canal **12c** de la couche de matériau semiconducteur **11.**

Les deux étapes illustrées en figures 6g et 6h peuvent être combinées dans une même étape de gravure RIE sous HBr/Cl₂/O₂, comme décrit dans la publication de R. Tiron et al., Sematech DSA Workshop 2010.

### Etape 9 :

On procède à la gravure du reste de l'oxyde de grille sacrificielle, en fond de cavité de grille, comme illustré en figure 6i, laissant à nu le canal avec ses perforations **22.**

Une quatrième série d'étapes permet de réaliser la grille du transistor présentant des perforations au niveau du canal :

### Etape 10 :

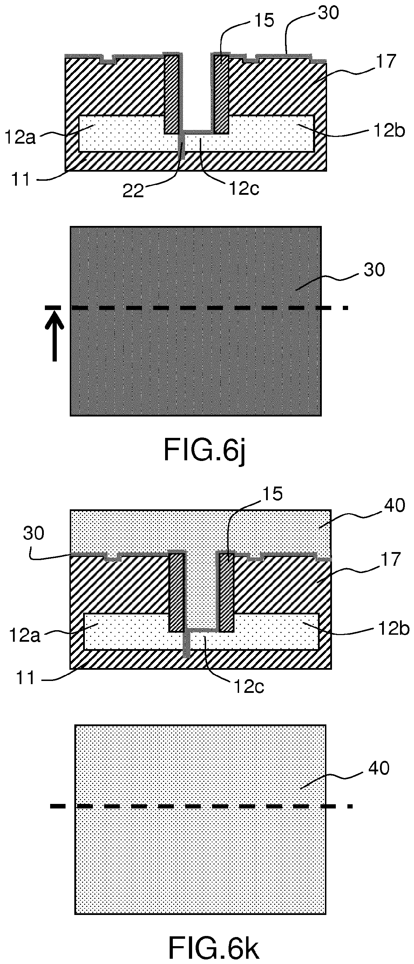

On procède au dépôt d'une couche d'isolant par exemple HfO₂. Il est avantageux d'utiliser un isolant présentant un fort module d'Young et que cet isolant remplisse les perforations pratiquées dans le canal car cette configuration est favorable au développement de la contrainte en cisaillement. La figure 6j, illustre le dépôt de cette couche **30** d'isolant.

### Etape 11 :

On procède au remplissage de la cavité par le dépôt d'au moins une couche d'au moins un matériau de grille **40** ou de plusieurs matériaux pouvant être par exemple un composé métallique comme du TiN ou du TaN et du silicium polycristallin, comme illustré en figure 6k.

### Etape 12 :

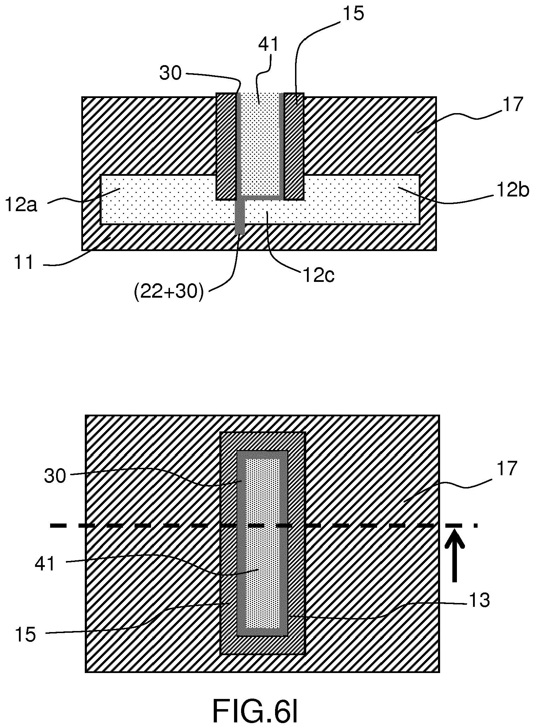

On procède au retrait des matériaux de grille extérieurs à la grille par polissage mécanochimique (CMP), pour ne laisser que la grille **41** du transistor ainsi obtenu intégrant des perforations remplies de matériau **30,** au niveau des bords de canal, comme illustré en figure 6l.

Le procédé précédemment décrit est particulièrement intéressant pour des dispositifs réalisés sur un film de matériau semiconducteur dans lequel on définit les fonctions source/canal/drain d'épaisseur t allant de 3 à environ 70nm. Les propriétés géométriques du réseau de perforations sont entièrement déterminées par la nature du copolymère à blocs. Ce copolymère est choisi/optimisé ainsi que le procédé de gravure de la phase PMMA pour obtenir des cylindres de diamètre pouvant aller d'environ trois nanomètres à une quinzaine de nanomètres.

Il est avantageux de réaliser des perforations typiquement de forme cylindrique, du plus faible diamètre possible de façon à minimiser la perte de matériau dans le canal, tout en garantissant la gravure du canal sur toute son épaisseur.

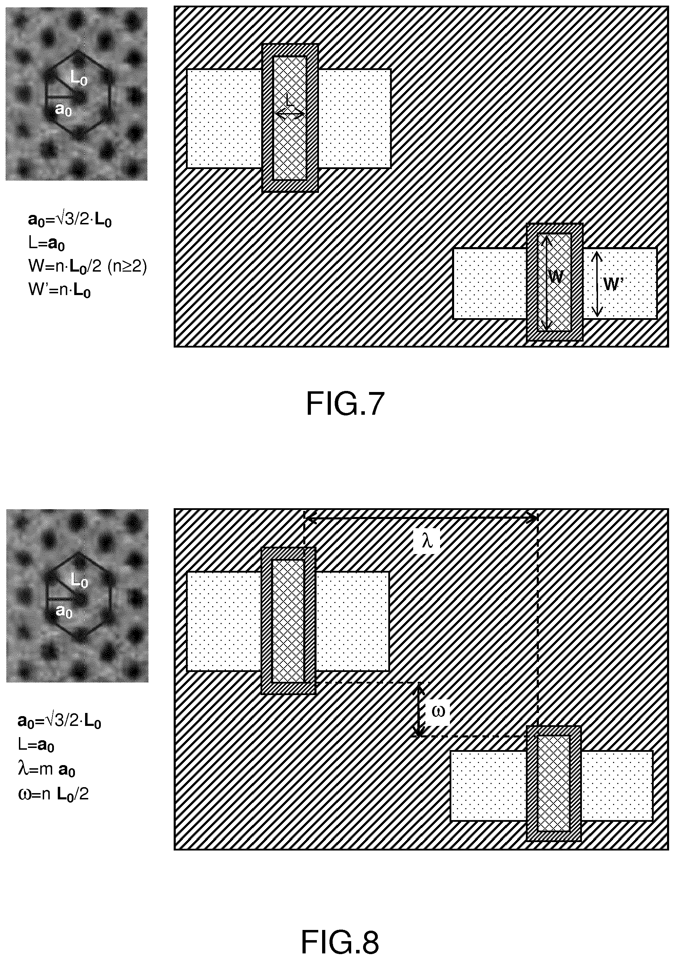

La figure 7 représente une vue de dessus, de deux transistors selon l'invention positionnés sur un même substrat et met en évidence les zones actives avec des grilles de dimension W dite largeur de grille selon l'axe y et de dimensions W' dite largeur de zone active.

Selon la présente invention, la périodicité spatiale du réseau de cylindres et donc de perforations doit être en accord avec les dimensions des cavités de grille, comme décrit dans l'article de R.Tiron et al. J.Vac.Sci. technol.B 29(6), Nov/Dec 2011 « Optimization of block copolymer self-assembly through graphoepitaxy. A deflectivity study ». Plus précisément, l'on cherche à accorder les distances entre bords de cavité de grille avec la périodicité du réseau de cylindres, comme illustré en figure 7 qui met en évidence également le paramètre a₀ = √3/2 L₀, avec L₀ la distance entre deux perforations, et L la dimension de canal selon l'axe x, on cherche à ce que L = a₀ = √3/2 L₀ et W = n L₀/2 avec n ≥ 2.

Si l'on souhaite garantir un nombre identique de perforations côté source et drain pour le transistor ainsi réalisé, il est nécessaire que la largeur (dimension selon l'axe y) de zone active W' corresponde à un multiple de distances entre cylindres, soit :
W' = nL₀

Lorsque l'on cherche à réaliser de manière collective un ensemble de transistors à la surface d'un même substrat, l'épaisseur de copolymère à blocs déposée peut s'avérer être conditionnante pour le positionnement des transistors les uns par rapport aux autres, comme il va être explicité ci-après.

### Première variante de réalisation collective de transistors selon la présente invention, utilisant un dépôt commun de copolymère à blocs :

Le dépôt d'une couche de copolymère à blocs présentant une épaisseur inférieure à la profondeur de cavité H (en pratique, H est de l'ordre de 20 à 60nm) est effectué. Dans ce premier mode de réalisation, les cavités peuvent être situées avantageusement de façon indépendante les unes par rapport aux autres.

### Seconde variante de réalisation collective de transistors selon la présente invention, utilisant un dépôt commun de copolymère à blocs :

Le copolymère à blocs est déposé avec une épaisseur supérieure à la profondeur de cavité H correspondant à une étape similaire à celle illustrée en figure 6d.

Ce mode de réalisation est avantageux pour la réalisation d'un réseau de copolymère sans défauts (la distance entre deux perforations voisines restant rigoureusement égale à L₀) (au sens du terme utilisé dans la publication de R.Tiron et al. J.Vac.Sci. technol.B 29(6), Nov/Dec 2011 « Optimization of block copolymer self-assembly through graphoepitaxy. A deflectivity study », mais il impose que les cavités soient situées de façon bien déterminée les unes par rapport aux autres, à la fois dans la direction de la longueur de canal L (distance À) selon l'axe x et dans la direction de la largeur de grille W (distance ω) selon l'axe y, comme illustré sur la figure 8. Ceci impose les conditions suivantes :
- la distance λ entre deux grilles adjacentes selon l'axe x, répond à l'équation suivante : λ = m.a₀ avec m entier ;
- la distance ω entre deux grilles adjacentes selon l'axe y répond à l'équation suivante : ω = n.L₀/2 avec n entier.

La figure 8 illustre ces deux distances λ et ω entre deux transistors adjacents.

### Exemple de réalisation d'un dispositif comprenant un ensemble de transistors selon l'invention :

La couche de copolymère à blocs utilisée pour réaliser les perforations peut avantageusement être du PS-*b*-PMMA contenant 70% de styrène en volume.

On procède au dépôt d'une couche de neutralisation qui pour le PS-*b*-PMMA peut être un polymère dit statistique, PS-*r*-PMMA, qui doit être suffisamment épais pour couvrir le fond et les flancs de la cavité de grille (typiquement préparé par étalement d'une solution à 3% en masse et étalée à 1500 rpm pour des cavités de profondeur autour de 60nm). L'étape d'étalement de la couche de polymère statistique est suivie d'une étape de recuit et de rinçage.

La distance L₀ entre cylindres (environ 36nm) correspond à une longueur de canal L optimale : a₀ de 31 nm [il est rappelé que cela est obtenu pour un polymère particulier et qu'il est possible en changeant de polymère (sa masse molaire) d'avoir accès à des pas variables (typiquement entre 20 et 60 nm avec le PS-b-PMMA)].

De la même façon, afin d'obtenir des motifs de perforation répétables et correctement positionnés, il est avantageux de recourir à des cavités de grille de largeur W optimales égales à un multiple supérieur à 2x de 18nm (demi-distance entre cylindres). On garantit des nombres identiques de perforations côté source et drain en utilisant des largeurs de zone active W' optimales multiples de 36nm.

Dans le cas où les cavités sont remplies avec une épaisseur de copolymère supérieure à la profondeur de cavité, l'espacement optimal entre cavités est un multiple de 31 nm dans la direction de L (distance λ) et un multiple de 18nm dans la direction de W (distance ω).

### Troisième variante de réalisation collective de transistors selon la présente invention, utilisant un dépôt commun de copolymère à blocs, dont seulement certains présentent des perforations au niveau du canal.

En effet, au sein d'un même circuit intégré, on peut sélectionner les dispositifs sur lesquels on souhaite réaliser des perforations.

En masquant les grilles où l'on ne souhaite pas réaliser de perforation, on ne retire pas la grille sacrificielle et on n'expose pas le canal à la gravure.

### Quatrième variante de réalisation collective de transistors selon la présente invention, dans laquelle les transistors ont des longueurs de canal différentes.

Des perforations peuvent être réalisées sur des dispositifs ayant des longueurs de canal L, selon l'axe x, différentes en répétant la séquence de perforation avec des copolymères différents (distance a₀) du copolymère qui détermine la longueur de grille pouvant recevoir les perforations.

La présente invention a été précédemment décrite dans le cadre de l'élaboration de perforations sur les deux bords du canal, il peut également être d'intérêt de ne réaliser des perforations que sur un seul bord de canal, comme cela est décrit dans la variante de réalisation ci-après.

### Variante de réalisation d'un transistor selon la présente invention, dans laquelle le canal du transistor présente des perforations sur un seul bord.

On peut réaliser des perforations sur un seul bord (Source ou Drain) de la cavité de grille en considérant des longueurs de canal L≤a₀, avec a₀ = √3/2 L₀, L₀ étant la distance entre deux perforations.

Dans ce cas, il faut aménager le procédé de fabrication pour contrôler le côté (Source ou Drain) de la cavité au niveau duquel on cherche à positionner les cylindres de PMMA.

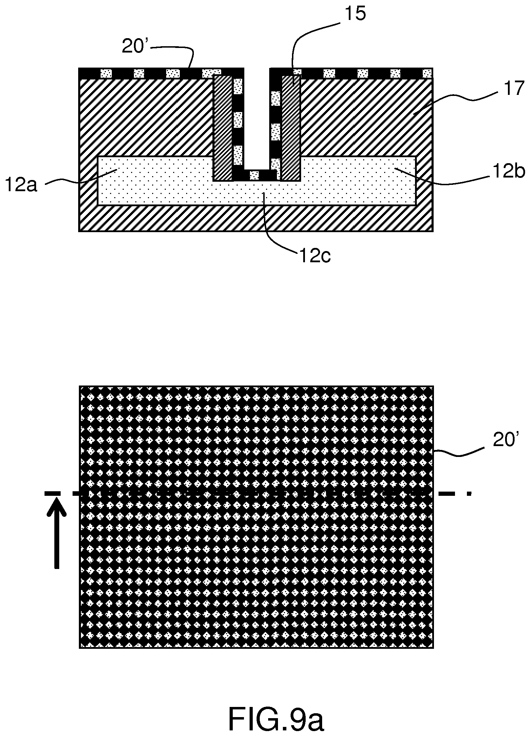

On vient déposer une couche de neutralisation **20'** pouvant être du PS-*r*-PMMA, comme illustré en figure 9a.

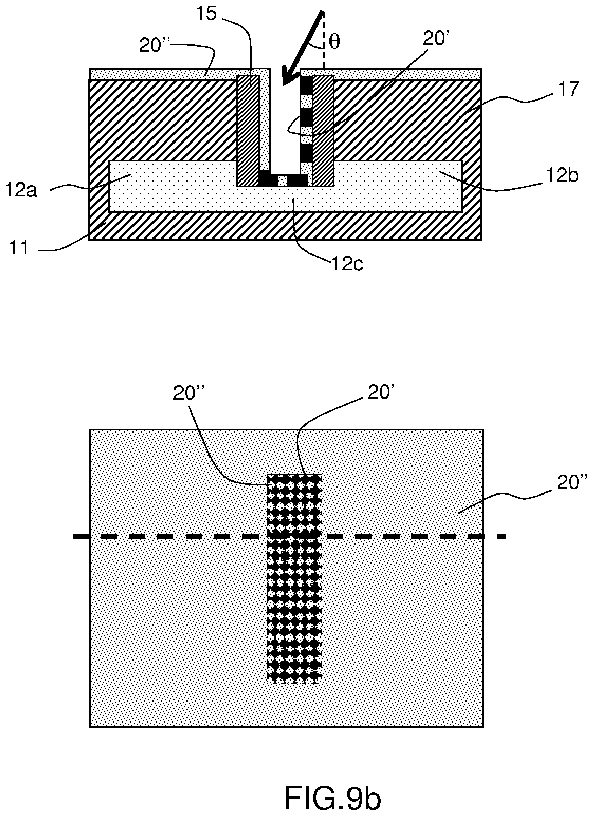

Dans une étape ultérieure, on fait disparaître la composante PMMA, générant une couche de matériau 20" du côté opposé à celui où on souhaite situer les demi-cylindres (respectivement Drain ou Source). Le traitement peut être une implantation ionique d'hydrogène (comme décrit dans la demande de brevet WO 2014/09662). On réalise cette opération de façon tiltée (avec un angle de tilt θ par rapport à la normale : θ = arctan(L/H)) pour n'affecter que certains flancs comme illustré en figure 9b.

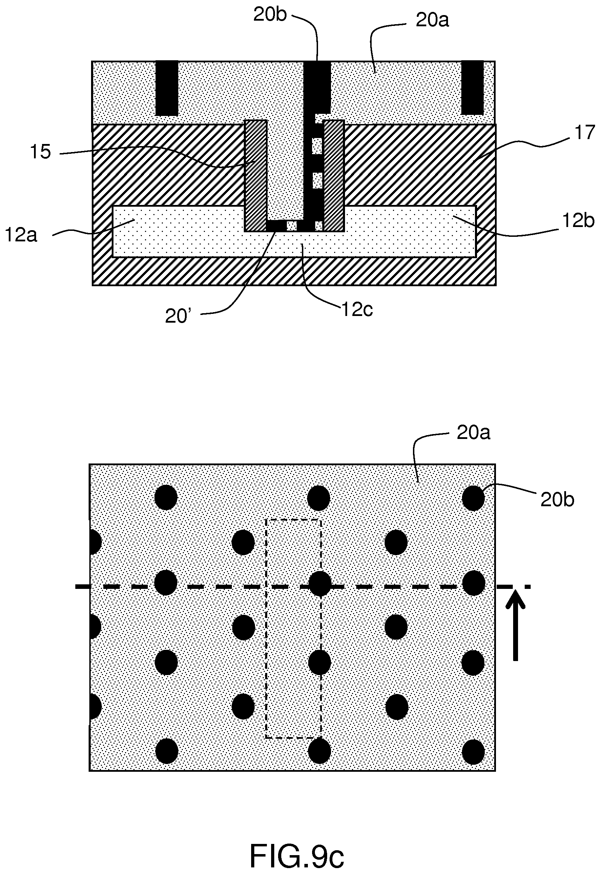

On vient alors déposer la couche de copolymère à blocs comprenant des motifs **20b** de PMMA dans du polystyrène **20a,** comme illustré en figure 9c qui met également en évidence le positionnement des perforations positionnées par rapport aux dimensions de la cavité de grille représentée en pointillés.

Les règles de commensurabilité s'appliquent de la même façon en W, et W', et par rapport aux bords de perforation pour les dimensions λ et ω que celles décrites précédemment.

Dans ces conditions, on obtient une contrainte moins importante mais le même copolymère à blocs permettant de perforer une gamme de dispositifs de longueurs de canal différentes (vérifiant toutes L≤a₀).

## Revendications

1. Transistor à effet de champ comportant une zone active présentant une source (12a), un canal (12c), un drain (12b), et une grille de commande positionnée au niveau dudit canal permettant la circulation d'un courant dans ledit canal entre la source et le drain selon un axe x, ledit canal comprenant :
- un premier bord de séparation avec ladite source
- un second bord de séparation avec ledit drain ;
- ledit canal étant contraint en tension ou en compression,
**caractérisé en ce que** ledit canal comporte une perforation (22) ou un ensemble de perforations localisée(s) le long uniquement dudit premier et/ou dudit second bord dudit canal de manière à créer également au moins une contrainte de cisaillement au niveau dudit canal.

2. Transistor selon la revendication 1, **caractérisé en ce qu'**il comprend une couche de matériau semiconducteur à la surface d'une couche d'oxyde enterrée (BOX), ladite couche de matériau semiconducteur étant précontrainte en tension ou en compression à la surface de ladite couche d'oxyde enterré.

3. Transistor selon la revendication 2, **caractérisé en ce que** le canal étant en silicium, ou en germanium ou dans un alliage SiGe, la source et le drain comprennent des espèces pouvant être des alliages d'éléments de la colonne IV, pour mettre le canal en tension ou en compression.

4. Transistor selon l'une des revendications précédentes, **caractérisé en ce que** la zone active est noyée dans une zone diélectrique présentant une partie supérieure, la grille étant située dans une cavité de grille définie dans ladite partie supérieure de ladite zone diélectrique.

5. Transistor selon l'une des revendications 1 à 4, **caractérisé en ce qu'**il comprend un ensemble de perforations distribuées en quinconce le long desdits premier et second bord du canal.

6. Transistor selon l'une des revendications 1 à 4, **caractérisé en ce qu'**il comprend un ensemble de perforations distribuées sur un seul bord de canal, côté source ou côté drain.

7. Transistor selon l'une des revendications 1 à 6, **caractérisé en ce que** la ou les perforations est(sont) remplie(s) par au moins un matériau de remplissage pouvant être un matériau présentant un module d'Young élevé supérieur ou égal à 200 GPa.

8. Transistor selon les revendications 4 et 7, **caractérisé en ce qu'**un des matériaux de remplissage de ladite(desdites) perforations(s) recouvre également les parois internes de la cavité de grille.

9. Transistor selon l'une des revendications 1 à 8, **caractérisé en ce que** les dimensions des perforations sont de l'ordre de quelques nanomètres, l'épaisseur du canal étant comprise entre quelques nanomètres et une centaine de nanomètres.

10. Transistor selon l'une des revendications 1 à 9, **caractérisé en ce que** la zone active présentant une largeur W' selon un axe y perpendiculaire à l'axe x, ladite largeur répond à l'équation suivante : W' = n L₀ avec n entier et L₀ la distance entre deux perforations adjacentes, les nombres de perforations le long du premier bord étant identique au nombre de perforations le long du second bord selon l'axe y.

11. Dispositif comprenant à la surface d'un substrat un ensemble de transistors sont selon l'une des revendications précédentes.

12. Dispositif selon la revendication 11, **caractérisé en ce que** les distances entre les cavités de grille des transistors répondent aux critères suivants :
- selon l'axe x et selon lequel est définie la longueur de canal L, la distance λ entre deux grilles adjacentes est égale à m.a₀, avec m entier et a₀ = √3/2 L₀ (λ = m.a₀), a₀ étant la distance entre deux rangées de perforations adjacentes ;
- selon l'axe y et selon lequel est définie la largeur de la zone active W', la distance ω entre deux grilles adjacentes est égale à n.L₀/2 avec n entier (ω = n.L₀/2).

13. Procédé de fabrication d'un transistor à effet de champ comportant une zone active présentant une source (12a), un canal (12c), un drain (12b), et une grille de commande (41) positionnée au niveau dudit canal permettant de contrôler un flux de porteurs de charge dans ledit canal, **caractérisé en ce qu'**il comprend les étapes suivantes :
- la réalisation d'une structure de transistor MOSFET comportant une source, un canal, un drain et une grille sacrificielle (14) au dessus dudit canal, ledit canal étant contraint en tension ou en compression ;
- le dépôt d'une couche diélectrique d'encapsulation de ladite structure avec un diélectrique pouvant être un oxyde ;
- la gravure sélective de ladite grille sacrificielle permettant de définir une cavité de grille au travers de ladite couche de diélectrique d'encapsulation ;
- le dépôt d'un copolymère à blocs comprenant une première espèce et une seconde espèce dans ladite cavité de grille présentant une première paroi interne côté source, dite premier bord du canal, et une seconde paroi interne côté drain, dite second bord du canal ;
- l'élimination de la première ou de la seconde espèce de manière à définir des motifs de masquage positionnés en regard d'au moins une desdites parois et débouchant en fond de cavité de grille ;
- la réalisation de perforation(s) localisée(s) le long uniquement dudit premier et/ou dudit second bord dudit canal
- le dépôt d'au moins un matériau de grille dans la cavité de grille en regard du canal perforé.

14. Procédé de fabrication d'un transistor à effet de champ selon la revendication 13, **caractérisé en ce qu'**il comprend une étape de remplissage de(des) perforation(s) avec au moins un matériau de 35 remplissage.

15. Procédé de fabrication d'un transistor à effet de champ selon l'une des revendications 13 ou 14, **caractérisé en ce qu'**il comprend le dépôt d'une couche de neutralisation, préalable au dépôt de la couche de copolymère à blocs, de manière à permettre une orientation privilégiée des perforations dans ledit canal.

16. Procédé de fabrication d'un transistor à effet de champ selon la revendication 15, **caractérisé en ce que** le copolymère à blocs est du PS-*b*-PMMA, le matériau de la couche de neutralisation étant du PS-*r*-PMMA.

17. Procédé de fabrication d'un transistor à effet de champ selon l'une des revendications 13 à 16, **caractérisé en ce qu'**il comprend le dépôt d'une couche de matériau de remplissage sur les parois internes de la cavité de grille par un matériau de remplissage, présentant un fort module d'Young supérieur ou égal à 200 GPa, pouvant être du HfO₂.

18. Procédé de fabrication d'un transistor à effet de champ selon l'une des revendications 15 à 17, **caractérisé en ce qu'**il comprend le traitement localisé de ladite couche de neutralisation de manière à ne rendre active ladite couche de neutralisation qu'au niveau d'un des deuxdits bords de drain ou de source.

19. Procédé de fabrication d'un transistor à effet de champ selon la revendication 18, **caractérisé en ce que** ledit traitement est réalisé avec un faisceau d'implantation ionique d'hydrogène faisant un angle de tilt θ = arctan(L/H) avec L la longueur du canal selon l'axe x et H la profondeur de ladite cavité de grille.

## Patentansprüche

1. Feldeffekttransistor, der eine aktive Zone mit einer Source (12a), einem Kanal (12c), einem Drain (12b) und einem Steuer-Gate beinhaltet, positioniert an dem Kanal, um das Umlaufen eines Stroms in dem Kanal zwischen der Source und dem Drain entlang einer Achse x zuzulassen, wobei der Kanal Folgendes umfasst:
- einen ersten Trennungsrand mit der Source;
- einen zweiten Trennungsrand mit dem Drain;
- wobei der Kanal auf Zug oder Druck beansprucht wird,
**dadurch gekennzeichnet, dass** der Kanal eine Perforation (22) oder einen Satz von Perforationen beinhaltet, die sich nur entlang des ersten und/oder zweiten Randes des Kanals befinden, um auch mindestens eine Scherbeanspruchung an dem Kanal zu erzeugen.

2. Transistor nach Anspruch 1, **dadurch gekennzeichnet, dass** er eine Halbleitermaterialschicht an der Oberfläche einer vergrabenen Oxidschicht (BOX) umfasst, wobei die Halbleitermaterialschicht an der Oberfläche der vergrabenen Oxidschicht auf Zug oder Druck vorgespannt ist.

3. Transistor nach Anspruch 2, **dadurch gekennzeichnet, dass**, da der Kanal aus Silicium oder Germanium oder aus einer SiGe-Legierung gefertigt ist, die Source und der Drain Spezies umfassen, die Legierungen von Elementen der Spalte IV sein können, um den Kanal unter Zug oder Druck zu setzen.

4. Transistor nach einem der vorherigen Ansprüche, **dadurch gekennzeichnet, dass** die aktive Zone in eine dielektrische Zone eingebettet ist, die einen oberen Teil aufweist, wobei sich das Gate in einem Gate-Hohlraum befindet, der im oberen Teil der dielektrischen Zone definiert ist.

5. Transistor nach einem der Ansprüche 1 bis 4, **dadurch gekennzeichnet, dass** er einen Satz von Perforationen umfasst, die entlang des ersten und zweiten Randes des Kanals versetzt verteilt sind.

6. Transistor nach einem der Ansprüche 1 bis 4, **dadurch gekennzeichnet, dass** er einen Satz von Perforationen umfasst, die an einem einzigen Rand des Kanals, auf der Source-Seite oder der Drain-Seite, verteilt sind.

7. Transistor nach einem der Ansprüche 1 bis 6, **dadurch gekennzeichnet, dass** die ein oder mehreren Perforationen mit mindestens einem Füllmaterial gefüllt ist (sind), das ein Material mit einem erhöhten Young-Modul von gleich oder größer als 200 GPa sein kann.

8. Transistor nach den Ansprüchen 4 bis 7, **dadurch gekennzeichnet, dass** eines der Füllmaterialien der ein oder mehreren Perforationen auch die Innenwände des Gate-Hohlraums abdeckt.

9. Transistor nach einem der Ansprüche 1 bis 8, **dadurch gekennzeichnet, dass** die Abmessungen der Perforationen in der Größenordnung von mehreren Nanometern sind, wobei die Dicke des Kanals mehrere Nanometer bis etwa hundert Nanometer beträgt.

10. Transistor nach einem der Ansprüche 1 bis 9, **dadurch gekennzeichnet, dass**, da die aktive Zone eine Breite W' in einer y-Achse senkrecht zur x-Achse aufweist, die Breite der folgenden Gleichung entspricht: W' = n L₀, wobei n eine ganze Zahl ist und L₀ der Abstand zwischen zwei benachbarten Perforationen ist, wobei die Anzahl von Perforationen entlang des ersten Randes identisch mit der Anzahl von Perforationen entlang des zweiten Randes gemäß der y-Achse ist.

11. Gerät, das an der Oberfläche eines Substrats einen Satz von Transistoren nach einem der vorherigen Ansprüche beinhaltet.

12. Gerät nach Anspruch 11, **dadurch gekennzeichnet, dass** die Abstände zwischen den Gate-Hohlräumen von den Transistoren die folgenden Kriterien erfüllen:
- entlang der x-Achse und gemäß der die Kanallänge L definiert wird, ist der Abstand λ zwischen zwei benachbarten Gates gleich m.a₀, wobei m eine ganze Zahl ist und a₀ = √3/2 L₀ (λ = m.a₀) ist, wobei a₀ der Abstand zwischen zwei benachbarten Perforationsreihen ist;
- entlang der y-Achse und gemäß der die Breite der aktiven Zone W' definiert wird, ist der Abstand ω zwischen zwei benachbarten Gates gleich n.L₀/2, wobei n eine ganze Zahl (ω = n.L₀/2) ist.

13. Verfahren zur Herstellung eines Feldeffekttransistors, beinhaltend eine aktive Zone mit einer Source (12a), einem Kanal (12c), einem Drain (12b) und einem Steuer-Gate (41), positioniert an dem Kanal, so dass ein Fluss von Ladungsträgern in dem Kanal gesteuert werden kann, **dadurch gekennzeichnet, dass** es die folgenden Schritte umfasst:
- Herstellen einer MOSFET-Transistorstruktur beinhaltend einer Source, einem Kanal, einem Drain und einem Opfer-Gate (14) über dem Kanal, wobei der Kanal auf Zug oder Druck beansprucht wird;
- Absetzen einer dielektrischen Verkapselungsschicht der Struktur mit einem Dielektrikum, das ein Oxid sein kann;
- selektives Ätzen des Opfer-Gate, so dass ein Gate-Hohlraum durch die dielektrische Verkapselungsschicht definiert werden kann;
- Absetzen eines Block-Copolymers umfassend einer ersten Spezies und einer zweiten Spezies in dem Gate-Hohlraum, der eine erste Innenwand auf der Source-Seite, erster Kanalrand genannt, und eine zweite Innenwand auf der Drain-Seite aufweist, zweiter Rand des Kanals genannt;
- Eliminieren der ersten oder zweiten Spezies, um Maskierungsmuster zu definieren, die gegenüber mindestens einer der Wände positioniert ist und am Boden des Gate-Hohlraums mündet;
- Herstellen von einer oder mehreren Perforationen, die sich nur entlang des ersten und/oder zweiten Randes des Kanals befindet/n;
- Absetzen mindestens eines Gate-Materials im Gate-Hohlraum gegenüber dem perforierten Kanal.

14. Verfahren zur Herstellung eines Feldeffekttransistors nach Anspruch 13, **dadurch gekennzeichnet, dass** es einen Schritt des Füllens von einer oder mehreren Perforationen mit mindestens einem Füllmaterial umfasst.

15. Verfahren zur Herstellung eines Feldeffekttransistors nach Anspruch 13 oder 14, **dadurch gekennzeichnet, dass** es das Absetzen einer Neutralisierungsschicht vor dem Absetzen der Block-Copolymer-Schicht umfasst, um eine bevorzugte Orientierung der Perforationen in dem Kanal zuzulassen.

16. Verfahren zur Herstellung eines Feldeffekttransistors nach Anspruch 15, **dadurch gekennzeichnet, dass** das Block-Copolymer PS-*b*-PMMA ist, wobei das Material der Neutralisierungsschicht PS-r-PMMA ist.

17. Verfahren zur Herstellung eines Feldeffekttransistors nach einem der Ansprüche 13 bis 16, **dadurch gekennzeichnet, dass** es das Absetzen einer Füllmaterialschicht an den Innenwänden des Gate-Hohlraums mit einem Füllmaterial umfasst, das ein hohes Young-Modul von gleich oder größer als 200 GPa aufweist, das HfO₂ sein kann.

18. Verfahren zur Herstellung eines Feldeffekttransistors nach einem der Ansprüche 15 bis 17, **dadurch gekennzeichnet, dass** es die lokalisierte Behandlung der Neutralisierungsschicht umfasst, um die Neutralisierungsschicht nur an einem der beiden Ränder von Drain oder Source aktiv zu machen.

19. Verfahren zur Herstellung eines Feldeffekttransistors nach Anspruch 18, **dadurch gekennzeichnet, dass** die Behandlung mit einem Wasserstoffionen-Implantationsstrahl erfolgt, der einen Neigungswinkel θ = arctan(L/H) bildet, wobei L die Länge des Kanals entlang der x-Achse und H die Tiefe des Gate-Hohlraums ist.

## Claims

1. Field-effect transistor including an active zone having a source (12a), a channel (12c), a drain (12b) and a control gate, which is positioned level with said channel, allowing a current to flow through said channel between the source and the drain along an x-axis, said channel comprising:
- a first edge of separation with said source;
- a second edge of separation with said drain;
- said channel being compressively or tensilely strained,
**characterized in that** said channel includes a perforation (22) or a set of perforations localized along only said first and/or second edge of said channel so as to also create at least one shear strain in said channel.

2. Transistor according to Claim 1, **characterized in that** it comprises a semiconductor layer on the surface of a buried oxide layer (BOX), said semiconductor layer being compressively or tensilely prestrained at the surface of said buried oxide layer.

3. Transistor according to Claim 2, **characterized in that**, the channel being made of silicon, or of germanium, or of an SiGe alloy, the source and the drain comprise species possibly being alloys of elements of column IV, in order to place the channel under tension or compression.

4. Transistor according to one of the preceding claims, **characterized in that** the active zone is embedded in a dielectric zone having an upper portion, the gate being located in a gate cavity defined in said upper portion of said dielectric zone.

5. Transistor according to one of claims 1 to 4, **characterized in that** it comprises a set of perforations staggered along said first and second edges of the channel.

6. Transistor according to one of claims 1 to 4, **characterized in that** it comprises a set of perforations distributed over a single source-side or drain-side channel edge.

7. Transistor according to one of claims 1 to 6, **characterized in that** the one or more perforations is (are) filled with at least one filling material, possibly a material with a high Young's modulus, higher than or equal to 200 GPa.

8. Transistor according to claims 4 and 7, **characterized in that** one of the filling materials of said perforation(s) also covers the internal walls of the gate cavity.

9. Transistor according to one of claims 1 to 8, **characterized in that** the dimensions of the perforations are of the order of a few nanometers, the thickness of the channel ranging between a few nanometers and about one hundred nanometers.

10. Transistor according to one of claims 1 to 9, **characterized in that** the active zone having a width W' along a y-axis perpendicular to the x-axis, said width respects the following equation: W' = n L₀ where n is an integer and L₀ is the distance between two adjacent perforations, the number of perforations along the first edge being identical to the number of perforations along the second edge along the y-axis.

11. Device comprising on the surface of a substrate a set of transistors according to one of the preceding claims.

12. Device according to Claim 11, **characterized in that** the distances between the gate cavities of the transistors meets the following criteria:
- along the x-axis and according to which the channel length L is defined, the distance λ between two adjacent gates is equal to m.a₀, where m is an integer and a₀ = √3/2 L₀ (λ = m.a₀), a₀ being the distance between two rows of adjacent perforations;
- along the y-axis and according to which the width of the active zone W' is defined, the distance ω between two adjacent gates is equal to n.L₀/2 where n is an integer (ω = n.L₀/2).

13. Method for fabricating a field-effect transistor including an active zone having a source (12a), a channel (12c), a drain (12b), and a control gate (41), which is positioned level with said channel, allowing a flow of charge carriers in said channel to be controlled, **characterized in that** it comprises the following steps:
- producing a MOSFET transistor structure including a source, a channel, a drain and a sacrificial gate (14) above said channel, said channel being compressively or tensilely strained;
- depositing a dielectric layer to encapsulate said structure with a dielectric that is possibly an oxide;
- selectively etching said sacrificial gate so as to define a gate cavity through said encapsulating dielectric layer;
- depositing a block copolymer comprising a first species and a second species in said gate cavity having a source-side first internal wall, called first channel edge, and a drain-side second internal wall, called second channel edge;
- removing the first or second species so as to define masking patterns positioned facing at least one of said walls and opening onto the bottom of the gate cavity;
- producing one or more perforations localized only along the first or the second edge of said channel;
- depositing at least one gate material in the gate cavity facing the perforated channel.

14. Method for fabricating a field-effect transistor according to Claim 13, **characterized in that** it comprises a step of filling one or more perforations with a least one filling material.

15. Method for fabricating a field-effect transistor according to either of claims 13 and 14, **characterized in that** it comprises the depositing of a neutralizing layer prior to the deposition of the block copolymer layer, so as to allow the perforations in said channel to be given a preferred orientation.

16. Method for fabricating a field-effect transistor according to claim 15, **characterized in that** the block copolymer is PS-*b*-PMMA, the material of the neutralizing layer being PS-*r*-PMMA.

17. Method for fabricating a field-effect transistor according to one of claims 13 to 16, **characterized in that** it comprises depositing a layer of filling material on the internal walls of the gate cavity by a filling material, having a high Young's modulus, higher than or equal to 200 GPa, possibly being HfO₂.

18. Method for fabricating a field-effect transistor according to one of claims 15 to 17, **characterized in that** it comprises localized treatment of said neutralizing layer so as to make said neutralizing layer active only at one of the two said drain or source edges.

19. Method for fabricating a field-effect transistor according to Claim 18, **characterized in that** said treatment is carried out with a hydrogen ion implantation beam making a tilt angle θ = arctan(L/H), where L is the length of the channel along the x-axis and H is the depth of said gate cavity.
